# EUROPEAN PATENT APPLICATION

(11) **EP 2 442 401 A1**
(43) Date of publication of application: **18.04.2012**
(21) Application number: 10786079.3
(22) Date of filing: 31.05.2010
(51) Int. Cl.: H01M 14/00, H01L 31/04

(54) **DYE-SENSITIZED PHOTOELECTRIC CONVERTER, MANUFACTURING METHOD THEREOF, AND ELECTRONIC DEVICE**

(30) Priority: 08.06.2009 JP 2009137279
(71) Applicant: Sony Corporation, Tokyo 108-0075 (JP)
(72) Inventor: ORIHASHI Masaki, Tokyo 108-0075 (JP); YONEYA Reiko, Tokyo 108-0075 (JP); MOROOKA Masahiro, Tokyo 108-0075 (JP); ISSHIKI Yusuke, Tokyo 108-0075 (JP); SUZUKI Yusuke, Tokyo 108-0075 (JP)
(74) Representative: Müller - Hoffmann & Partner
(86) International application number: PCT/JP2010/059176
(87) International publication number: WO 2010/143548

(57) **Abstract**

The present invention relates to a dye-sensitized photoelectric conversion element and a method for manufacturing the same which provide a dye-sensitized photoelectric conversion element capable of solving the problem of decreasing the efficiency of photoelectric conversion over time and significantly improving durability, and a method for manufacturing the same, and also relates to an electronic apparatus.

A dye-sensitized photoelectric conversion element has a structure in which an electrolyte layer 7 is filled between a semiconductor layer 3 and a counter electrode 6. Z907 and dye A are bounded in different configurations as photosensitizing dyes to the semiconductor layer 3. The electrolyte layer 7 contains 3-methoxypropionitrile as a solvent.

## Description

### Technical Field

The present invention relates to a dye-sensitized photoelectric conversion element and a method for manufacturing the same and an electronic apparatus. In more detail, the present invention relates to a dye-sensitized photoelectric conversion element suitable for use for a dye-sensitized solar cell and the like which are required to have durability and a method for manufacturing the same, and to an electronic apparatus using the dye-sensitized photoelectric conversion element.

### Background Art

Solar cells serving as photoelectric conversion elements which convert solar light to electric energy use solar light as an energy source and thus have very small influences on the global environment and are expected to further prevail.
As solar cells, crystal silicon solar cells using single crystal or polycrystalline silicon and amorphous silicon solar cells have been mainly used.

On the other hand, a dye-sensitized solar cell proposed by Gratzel etc. in 1991 attracts attention because it can achieve a high efficiency of photoelectric conversion, does not require a large apparatus for manufacturing unlike conventional silicon solar cells, and can be manufactured at low cost (refer to, for example, Non Patent Literature 1).

A general structure of this dye-sensitized solar cell is formed by opposing a dye-sensitized porous semiconductor layer including a porous semiconductor layer of titanium oxide to a counter electrode provided by forming a platinum layer on a substrate, the porous semiconductor layer being formed on a transparent conductive substrate and supporting a photosensitizing dye; sealing the peripheries with a sealing material; and filling a space between both electrodes with an electrolyte containing oxidation-reduction species such as iodine and iodide ions.

In recent years, a dye-sensitized photoelectric conversion element has been proposed, in which a photoelectric conversion efficiency is improved by supporting plural types of photosensitizing dyes in a semiconductor layer (refer to, for example, Patent Literature 1). Examples of the plural types of photosensitizing dyes to be supported in the semiconductor layer include combinations of N719 and dye A, a black dye (N749) and dye A, and dye B and dye A. N719 is a type of bipyridine complex, a cis-bis(isothiocyanato)bis(2,2'-bipyridyl-4,4'-dicarboxylato) ruthenium(II) bis-tetrabutylammonium complex. The black dye is a type of terpyridine complex, a tris(isothiocyanato)(2,2':6',2"-terpyridyl-4,4',4"-tricarboxylato) ruthenium(II) tristetrabutylammonium complex. The dye B is 5-[[4-[4-(2,2-diphenylethenyl)phenyl]-1,2,3,3a,4,8b-hexahydrocyclopent[b]indol-7-yl]methylene]-2-(3-ethyl-4-oxo-2-thioxo-5-thiazolidinylidene)-4-oxo-3-Thiazolidineacetic acid. The dye A is 2-Cyano-3-[4-[4-(2,2-diphenylethenyl)phenyl]-1,2,3,3a,4,8b-hexahydrocyclopent[b]indol-7-yl]-2-propenoic acid. According to Patent Literature 1, when N719 and the dye A are supported in a semiconductor layer, a high efficiency of photoelectric conversion is achieved in comparison with a case in which only N719 is supported in a semiconductor layer. In addition, when the black dye and the dye A are supported in a semiconductor layer, a high efficiency of photoelectric conversion is achieved in comparison with a case in which only the black dye is supported in a semiconductor layer. Further, when the dye B and the dye A are supported in a semiconductor layer, a high efficiency of photoelectric conversion is achieved in comparison with a case in which only the dye B is supported in a semiconductor layer.

### Citation List

### Non Patent Literature

NPL 1: Nature, 353, p. 737-740, 1991

### Patent Literature

PTL 1: Japanese Unexamined Patent Application Publication No. 2007-234580

### Summary of Invention

### Technical Problem

However, according to research performed by the inventors of the present invention, a dye-sensitized photoelectric conversion element using a combination of N719 and the dye A, the black dye and the dye A, or the dye B and the dye A as plural types of photosensitizing dyes supported in a semiconductor layer has insufficient durability. In more detail, in the dye-sensitized photoelectric conversion element, a high efficiency of photoelectric conversion is achieved in an early stage in comparison with a case in which only the N719, the black dye, or the dye B is supported in a semiconductor layer, but the efficiency of photoelectric conversion decreases over time.

Accordingly, a problem to be solved by the invention is to provide a dye-sensitized photoelectric conversion element capable of solving the problem of decreasing the efficiency of photoelectric conversion over time and significantly improving durability, and a method for manufacturing the same.
Another problem to be solved by the invention is to provide an excellent electronic apparatus using the dye-sensitized photoelectric conversion element.

### Solution to Problem

The inventors intensively conducted research for improving the durability of a dye-sensitized photoelectric conversion element using a semiconductor layer which supports plural types of dyes. As a result, the inventors have found quite by chance a combination of photosensitizing dyes capable of forming a dye-sensitized photoelectric conversion element having excellent durability and causing substantially no decrease in a photoelectric conversion efficiency over time, and an optimum electrolyte layer solvent used for the combination of photosensitizing dyes.

That is, in order to solve the problems, the present invention relates to a dye-sensitized photoelectric conversion element having:
a structure in which an electrolyte layer is filled between a semiconductor layer and a counter electrode,
wherein Z907 and dye A are bonded as photosensitizing dyes to the semiconductor layer; and
the electrolyte layer contains 3-methoxypropionitrile as a solvent.

Also, the present invention relates to a method for manufacturing a dye-sensitized photoelectric conversion element including:
a step of bonding Z907 and dye A as photosensitizing dyes to a semiconductor layer; and
a step of forming a structure in which an electrolyte layer is filled between the semiconductor layer and a counter electrode, the electrolyte layer containing 3-methoxypropionitrile as a solvent in this step.

Further, the present invention relates to an electronic apparatus including:
at least one dye-sensitized photoelectric conversion element,
wherein the dye-sensitized photoelectric conversion element is a dye-sensitized photoelectric conversion element having a structure in which an electrolyte layer is filled between a semiconductor layer and a counter electrode;
Z907 and dye A are bonded as photosensitizing dyes to the semiconductor layer; and
the electrolyte layer contains 3-methoxypropionitrile as a solvent.

The Z907 and the dye A as the photosensitizing dyes are typically bonded in different configurations to the semiconductor layer by adsorption. Typically, the Z907 has a carboxyl group (-COOH) as a functional group bonded to the semiconductor layer, and the dye A has a carboxyl group (-COOH) and a cyano group (-CN) as functional groups bonded to the semiconductor layer, both groups being bonded to the same carbon.

The electrolyte layer filled between the semiconductor layer and the counter electrode is typically an electrolytic solution or a gel or solid electrolyte. Preferably, the electrolyte layer includes a nanocomposite gel including an electrolytic solution and nanoparticles, and the nanoparticles are typically composed of TiO₂ or SiO₂ but are not limited to this.
The dye-sensitized photoelectric conversion element is most typically configured as a dye-sensitized solar cell. However, the dye-sensitized photoelectric conversion element may be other than the dye-sensitized solar cell, for example, a dye-sensitized photosensor or the like.
The electronic apparatus may be basically any type and includes both a portable type and a stationary type, but examples thereof include a cellular phone, a mobile device, a robot, a personal computer, an automobile-installed equipment, various home electric appliances, and the like. In this case, the dye-sensitized photoelectric conversion element is, for example, a dye-sensitized solar cell used as a power supply of such an electronic apparatus.

In the present invention configured as described above, the Z907 and the dye A are used as photosensitizing dyes to be bonded to the semiconductor layer, and 3-methoxypropionitrile is used as a solvent to be contained in the semiconductor layer, i.e., a solvent used for preparing the electrolyte layer, so that the efficiency of photoelectric conversion of the dye-sensitized photoelectric conversion element can be suppressed from decreasing over time.

### Advantageous Effects of Invention

According to the present invention, it is possible to provide a dye-sensitized photoelectric conversion element having high durability because the efficiency of photoelectric conversion can be prevented from decreasing over time. In addition, a high-performance electronic apparatus can be realized using the excellent dye-sensitized photoelectric conversion element.

### Brief Description of Drawings

[Fig. 1] Fig. 1 is a sectional view showing a dye-sensitized photoelectric conversion element according to a first embodiment of the present invention.
[Fig. 2] Fig. 2 is a schematic diagram showing a structural formula of Z907 bonded as a photosensitizing dye to a semiconductor layer in the dye-sensitized photoelectric conversion element according to the first embodiment of the present invention.
[Fig. 3] Fig. 3 is a schematic diagram showing the measurement result of an IPCE spectrum of a dye-sensitized photoelectric conversion element including only Z907 bonded to a semiconductor layer.
[Fig. 4] Fig. 4 is a schematic diagram showing a structural formula of dye A bonded as a photosensitizing dye to a semiconductor layer in the dye-sensitized photoelectric conversion element according to the first embodiment of the present invention.
[Fig. 5] Fig. 5 is a schematic diagram showing the measurement result of an IPCE spectrum of a dye-sensitized photoelectric conversion element including only dye A bonded to a semiconductor layer.
[Fig. 6] Fig. 6 is a schematic diagram for explaining an operation principle of the dye-sensitized photoelectric conversion element according to the first embodiment of the present invention.
[Fig. 7] Fig. 7 is a schematic diagram showing the measurement result of an IPCE spectrum of the dye-sensitized photoelectric conversion element according to the first embodiment of the present invention together with the measurement result of a comparative example.
[Fig. 8] Fig. 8 is a schematic diagram showing the measurement results of changes in photoelectric conversion efficiency over time of the dye-sensitized photoelectric conversion element according to the first embodiment of the present invention together with the measurement results of a comparative example.

### Description of Embodiments

Hereinafter, modes for carrying out the invention (referred to as "embodiments" hereinafter) are described.
In addition, a description is made in the following order:
1. First embodiment (a dye-sensitized photoelectric conversion element and a method for manufacturing the same)
2. Second embodiment (a dye-sensitized photoelectric conversion element and a method for manufacturing the same)

### <1. First Embodiment>

### [Dye-sensitized photoelectric conversion element]

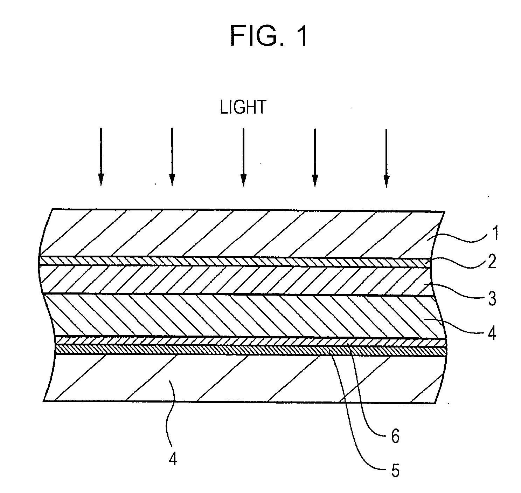

Fig. 1 is a main part sectional view showing a dye-sensitized photoelectric conversion element according to a first embodiment of the present invention.
As shown in Fig. 1, in the dye-sensitized photoelectric conversion element, a transparent electrode 2 is provided on a main surface of a transparent substrate 1, and a semiconductor layer (semiconductor electrode) 3 is provided on the transparent electrode 2. As described below, Z907 and dye A as photosensitizing dyes are adsorbed in different configurations on the semiconductor layer 3. On the other hand, a transparent conductive layer 5 is provided on a main surface of a counter substrate 4, and a counter electrode 6 is provided on the transparent conductive layer 5. In addition, an electrolyte layer 7 is filled between the semiconductor layer 3 on the transparent substrate 1 and the counter electrode 6 on the counter substrate 4, and the peripheries of the transparent substrate 1 and the counter substrate 4 are sealed with a sealing material (not shown).

As the semiconductor layer 3, typically, a porous film formed by sintering semiconductor fine particles is used, and Z907 and dye A are adsorbed as photosensitizing dyes on the surfaces of the semiconductor fine particles. As a material of the semiconductor fine particles, an elemental semiconductor such as silicon, a compound semiconductor, a semiconductor having a perovskite structure, and the like can be used. Such semiconductors are preferably n-type semiconductors in which conduction-band electrons serve as carriers under light excitation to produce an anode current. Specifically, semiconductors, for example, such as titanium oxide (TiO₂), zinc oxide (ZnO), tungsten oxide (WO₃), niobium oxide (Nb₂O₅), strontium titanate (SrTiO₃), tin oxide (SnO₂), and the like can be used. Among these semiconductors, TiO₂ particularly anatase-type TiO₂ is preferably used. However, the types of semiconductors are not limited to these, and a mixture or complex of two or more semiconductors can be used according to demand. In addition, the form of the semiconductor fine particles may be any one of a particle, a tube, a rod, and the like.

The particle diameter of the semiconductor fine particles is not particularly limited, but is preferably 1 to 200 nm, particularly preferably 5 to 100 nm, in terms of the average particle diameter of primary particles. In addition, particles with a size larger than the semiconductor fine particles can be mixed so that the quantum yield can be improved by scattering incident light by the particles. In this case, the average size of the other particles mixed is preferably 20 to 500 nm, but is not limited to this.

The semiconductor layer 3 preferably has a large actual surface area including the surfaces of the fine particles which face the holes in the porous film so that as many photosensitizing dyes as possible can be adsorbed. Therefore, the actual surface area of the semiconductor layer 3 in a state of being formed on the transparent electrode 2 is preferably 10 times or more, more preferably 100 times or more, the outer surface (protected area) of the semiconductor layer 3. There is no particular upper limit of this ratio, but the ratio is generally about 1000 times.

In general, as the thickness of the semiconductor layer 3 increases to increase the number of the semiconductor fine particles contained per unit projected area, the actual surface area increases to increase the amount of the photosensitizing dyes which can be supported in the unit projected area, thereby increasing the light absorptance.
On the other hand, an increase in thickness of the semiconductor layer 3 increases the distance for which electrons transferred from the photosensitizing dye to the semiconductor layer 3 diffuse until they reach the transparent electrode 2, thereby increasing an electron loss due to charge recoupling in the semiconductor layer 3. Therefore, there is a preferred thickness for the semiconductor layer 3, but the thickness is generally 0.1 to 100 µm, more preferably 1 to 50 µm, and particularly preferably 3 to 30 µm.

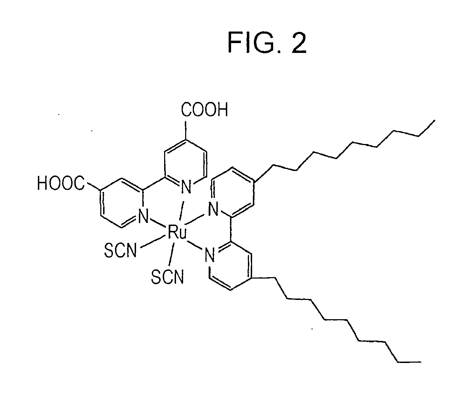

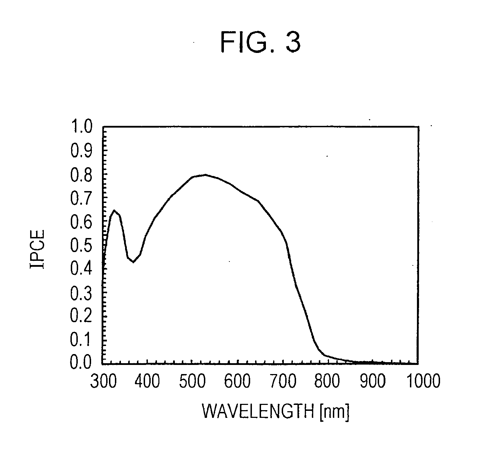

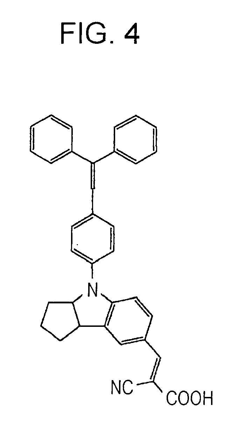

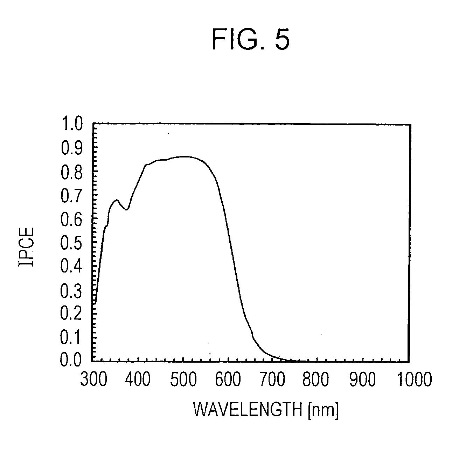

The Z907 and the dye A serving as photosensitizing dyes are bonded in different configurations to a surface of the semiconductor layer 3 by adsorption. Fig. 2 shows a structural formula of the Z907, and Fig. 3 shows the measurement result of an IPCE (Incident Photon-to-current Conversion Efficiency) spectrum when only the Z907 was adsorbed on a surface of the semiconductor layer 3. Fig. 4 shows a structural formula of the dye A, and Fig. 5 shows the measurement result of an IPCE spectrum when only the dye A was adsorbed on a surface of the semiconductor layer 3.
As shown in Figs. 3 and 5, Z907 can absorb light within a wide wavelength range, but a region with insufficient absorbance is present in a short-wavelength region, and the dye A having large absorbance in the short-wavelength region has a relation in which the dye A assists light absorption in the short-wavelength region. That is, the dye A functions as a photosensitizing dye having large absorbance in the short-wavelength region.

As shown in Fig. 2, Z907 has a carboxyl group (-COOH) as a functional group strongly bonded to the semiconductor layer 3, the carboxyl group being bonded to the semiconductor layer 3. In contrast, as shown in Fig. 4, the dye A has a carboxyl group (-COOH) as a functional group strongly bonded to the semiconductor layer 3 and a cyano group (-CN) as a functional group weakly bonded to the semiconductor layer 3, both functional groups being bonded to the same carbon. In addition, in the dye A, the carboxyl group and the cyano group which are bonded to the same carbon are bonded to the semiconductor layer 3. That is, the dye A is adsorbed on the semiconductor layer 3 through the carboxyl group and the cyano group bonded to the same carbon and is thus adsorbed on the semiconductor layer 3 in a configuration different from the Z907 adsorbed on the semiconductor layer 3 through only the carboxyl group. Here, if a plurality of functional groups bonded to the same carbon in the dye A are all functional groups strongly bonded to the semiconductor layer 3, the degree of freedom of configuration of the dye A adsorbed on the semiconductor layer 3 is decreased, and thus the effect of the presence of a plurality of functional groups bonded to the same carbon is little exhibited. In contrast, in the dye A, the cyano group weakly bonded to the semiconductor layer 3 has an auxiliary function and does not interfere with strong bonding of the carboxyl group to the semiconductor layer 3. As a result, the dye A effectively exhibits the effect of the carboxyl group and the cyano group bonded to the same carbon. Namely, the dye A and the Z907 can coexist without strong interaction therebetween even if they are adjacent to each other on the surface of the semiconductor layer 3, and thus the photoelectric conversion performances thereof are not deteriorated by each other. On the other hand, the dye A lies between Z907 molecules bonded to the same surface of the semiconductor layer 3, thereby suppressing association of Z907 and preventing useless electron transfer between Z907 molecules. Therefore, exited electrons of Z907 which absorbs light are efficiently drawn to the semiconductor layer 3 without useless transfer between Z907 molecules, thereby improving the photoelectric conversion efficiency of Z907. In addition, exited electrons of the dye A which absorbs light are drawn to the semiconductor layer 3 from the carboxyl group strongly boned thereto, thereby causing efficient charge transfer to the semiconductor layer 3.

As the electrolyte constituting the electrolyte layer 7, an electrolytic solution or a gel or solid electrolyte can be used. As the electrolytic solution, a solution containing an oxidation-reduction system (redox pair) can be used, and specifically, a combination of iodine I₂ and a metal or organic iodide salt, a combination of bromine Br₂ and a metal or organic bromide salt, or the like can be used. Examples of a cation constituting a metal salt include lithium Li⁺, sodium Na⁺, potassium K⁺, cesium Cs⁺, magnesium Mg²⁺, calcium Ca²⁺, and the like. In addition, as a cation constituting an organic salt, tetraalkylammonium ions, pyridinium ions, imidazolium ions, tertiary ammonium ions, and the like are preferred, and these can be used lone or in a mixture of two or more.

As the electrolyte constituting the electrolyte layer 7, besides the above, a metal complex such as a combination of a ferrocyanate and a ferricyanate, a combination of ferrocene and ferricinium ion, or the like; an sulfur compound such as polysodium sulfide or a combination of alkylthiol and alkyl disulfide; a viologen dye; a combination of hydroquinone and quinone; or the like can be used.

Among the above, as the electrolyte constituting the electrolyte layer 7, an electrolyte including a combination of iodine I₂ and lithium iodide LiI, sodium iodide NaI, or a tertiary ammonium compound such as imidazolium iodide is particularly preferred. The concentration of the electrolyte salt is preferably 0.05 M to 10 M and more preferably 0.2 M to 3 M based on the solvent. The concentration of iodine I₂ or bromine Br₂ is preferably 0.0005 M to 1 M and more preferably 0.001 to 0.5 M. In addition, any of various additives such as 4-tert-butylpyridine, benzimidazolium, and the like can be added for improving an open-circuit voltage and a short-circuit current.

As a solvent constituting the electrolytic solution, generally, water, alcohols, ethers, esters, carbonates, lactones, carboxylates, phosphate triesters, heterocyclic compounds, nitriles, ketones, amides, nitromethane, hologenated hydrocarbon, dimethyl sulfoxide, sulfolane, N-methylpyrrolidone, 1,3-dimethylimidazolidinone, 3-methyloxazolidinone, hydrocarbon, and the like can be used, but in particular, 3-methoxypropionitrile (MPN) is used for the dye-sensitized photoelectric conversion element. As described below, by using 3-methoxypropionitrile as the solvent constituting the electrolytic solution, durability of the dye-sensitized photoelectric conversion element including the Z907 and the dye A bonded as photosensitizing dyes to the semiconductor layer 3 can be improved.

For the purpose of decreasing leakage of the electrolytic solution from the dye-sensitized photoelectric conversion element and evaporation of the solvent constituting the electrolytic solution, an electrolyte constituent may be mixed with a gelling agent, a polymer, or a crosslinking monomer by dissolution or dispersion so that it can be used as a gel electrolyte. With respect to a ratio between the gelled material and the electrolyte constituent, when the amount of the electrolyte constituent is large, ionic conductivity is increased, but mechanical strength is decreased, and conversely when the amount of the electrolyte constituent is excessively small, mechanical strength is increased, but ionic conductivity is decreased. Therefore, the amount of the electrolyte constituent is preferably 50 wt% to 99 wt%, more preferably 80 wt% to 97 wt%, of the gel electrolyte. In addition, an all-solid-state photosensitized photoelectric conversion element can be realized by mixing an electrolyte and a plasticizer with a polymer and then evaporating the plasticizer.

The transparent substrate 1 is not particularly limited as long as the material and shape easily transmit light, and various substrate materials can be used, but a substrate material having high visible light transmittance is particularly preferably used. In addition, a material having high shielding performance of inhibiting moisture and gases from entering the dye-sensitized photoelectric conversion element from the outside and also having excellent solvent resistance and weather resistance is preferred. Examples of a material of the transparent substrate 1 include transparent inorganic materials such as quartz, glass, and the like; and transparent plastics such as polyethylene terephthalate, polyethylene naphthalate, polycarbonate, polystyrene, polyethylene, polypropylene, polyphenylene sulfide, polyvinylidene fluoride, acetyl cellulose, phenoxy bromide, aramids, polyimides, polystyrenes, polyarylates, polysulfones, polyolefins, and the like. The thickness of the transparent substrate 1 is not particularly limited and can be appropriately selected in consideration of light transmittance and the performance of shielding the inside of the photoelectric conversion element from the outside.

As the transparent electrode 2 provided on the transparent substrate 1, a transparent conductive layer can be used. The transparent conductive layer preferably has as low sheet resistance as possible, specifically preferably 500 Ω/□ or less and more preferably 100 Ω/□ or less. As a material for forming the transparent conductive layer, a known material can be used, and the material is selected according to demand. Examples of the material for forming the transparent conductive layer include indium-tin compound oxide (ITO), fluorine-doped tin(IV) oxide SnO₂ (FTO), tin(IV) oxide SnO₂, zinc(II) oxide ZnO, indium-zinc compound oxide (IZO), and the like. However, the material for forming the transparent conductive layer is not limited to these, and combination of two or more can be used.

As a material for the counter electrode 4, opaque glass, plastic, ceramic, a metal, or the like may be used, and a transparent material, for example, transparent glass, plastic, or the like, may be used.
As the transparent conductive layer 5, the same as the transparent conductive layer used for the transparent electrode 2 can be used.
As a material for the counter electrode 6, any material can be used as long as it is a conductive material, but an insulating material can also be used if a conductive layer is formed on a side facing the electrolyte layer 5. As the material for the counter electrode 6, an electrochemically stable material is preferably used, specifically platinum, gold, carbon, conductive polymer, and the like are preferably used.

In addition, in order to improve a catalytic function in reduction reaction on the counter electrode 6, a microstructure is preferably formed in a surface of the counter electrode 6, which is in contact with the electrolyte layer 7, so that the actual surface area is increased, and for example, preferably, platinum is formed in a platinum black state, and carbon is formed in a porous carbon state. The platinum black can be formed by a method of anodization or chloroplatinic acid treatment of platinum, and the porous carbon can be formed by a method of sintering carbon fine particles or firing an organic polymer.

### [Method for manufacturing dye-sensitized photoelectric conversion element]

Next, the method for manufacturing the dye-sensitized photoelectric conversion element is described.
First, a transparent conductive layer is formed on a main surface of the transparent substrate 1 by a sputtering method to form the transparent electrode 2.
Next, the semiconductor layer 3 is formed on the transparent electrode 2. The method for forming the semiconductor layer 3 is not particularly limited, but a wet film forming method is preferably used in consideration of physical properties, convenience, manufacturing cost, and the like. The wet film forming method is preferably a method in which a powder or sol of semiconductor fine particles is uniformly dispersed in a solvent such as water to prepare a paste dispersion solution, and the dispersion solution is applied or printed on the transparent electrode 2 of the transparent substrate 1. The method for applying or printing the dispersion solution is not particularly limited, and a known method can be used. Specifically, as the application method, for example, a dipping method, a spray method, a wire bar method, a spin coating method, a roller coating method, a blade coating method, a gravure coating method, or the like can be used. In addition, as the printing method, a relief printing method, an offset printing method, a gravure printing method, an intaglio printing method, a rubber plate printing method, a screen printing method, or the like can be used.

When anatase-type TiO₂ is used as a material of semiconductor fine particles, commercial powder, sol, or slurry anatase-type TiO₂ may be used, or anatase-type TiO₂ having a predetermined particle diameter may be formed by a known method of hydrolyzing titanium oxide alkoxide. When a commercial powder is used, secondary aggregation of particles is preferably eliminated, and thus the particles are preferably ground using a mortar or ball mill when a paste dispersion solution is prepared. In this case, acetylacetone, hydrochloric acid, nitric acid, a surfactant, and a chelating agent can be added to the paste dispersion solution in order to prevent re-aggregation of the particles in which secondary aggregation is eliminated. In addition, a polymer such as polyethylene oxide or polyvinyl alcohol, or a thickener such as a cellulose thickener ca be added to the paste dispersion solution in order to increase the viscosity of the paste dispersion solution.

After the semiconductor fine particles are applied or printed on the transparent electrode 2, the semiconductor layer 3 is preferably fired in order to electrically connect the semiconductor fine particles to each other and to improve the mechanical strength of the semiconductor layer 3 and adhesion to the transparent electrode 2. The firing temperature range is not particularly limited, but at an excessively high temperature, the electric resistance of the transparent electrode 2 is increased, and further the transparent electrode 2 may be molten. Therefore, the temperature is generally 40 to 700°C and more preferably 40 to 650°C. In addition, the firing time is also not particularly limited but is generally about 10 minute to 10 hours.

After firing, for example, dipping treatment may be performed with an aqueous titanium tetrachloride solution or a titanium oxide ultrafine particle sol having a diameter of 10 nm or less for the purpose of increasing the surface area of the semiconductor fine particles and enhancing necking between the semiconductor fine particles. When a plastic substrate is used as the transparent substrate 1 which supports the transparent electrode 2, the semiconductor layer 3 can be formed on the transparent electrode 2 using a paste dispersion solution containing a binder and then pressure-bonded to the transparent electrode 2 by heat pressing.

Next, the transparent substrate 1 with the semiconductor layer formed thereon is dipped in a photosensitizing dye solution containing the Z907 and the dye A dissolved in a predetermined solvent to adsorb the Z907 and the dye A on the semiconductor layer 3. In this case, a carboxyl group of the Z907 is bonded to the semiconductor layer 3, and a carboxyl group and a cyano group bonded to the same carbon of the dye A are bonded to the semiconductor layer 3.

On the other hand, the transparent conductive layer 5 and the counter electrode 6 are formed in order on the counter substrate 4 by a sputtering method or the like.
Next, the transparent substrate 1 and the counter substrate 4 are disposed so that the semiconductor layer 3 and the counter electrode 6 face each other with a predetermined space of, for example, 1 to 100 µm, preferably 1 to 50 µm, therebetween. Then, a sealing material (not shown) is formed in the peripheries of the transparent substrate 1 and the counter substrate 4 to form a space in which the electrolyte layer 7 is sealed, and the electrolyte layer 7 is injected into the space from, for example, an injection hole (not shown) previously formed in the transparent substrate 1. Then, the injection hole is sealed.
As a result, the intended dye-sensitized photoelectric conversion element is manufactured.

### [Operation of dye-sensitized photoelectric conversion element]

Next, the operation of the dye-sensitized photoelectric conversion element is described.

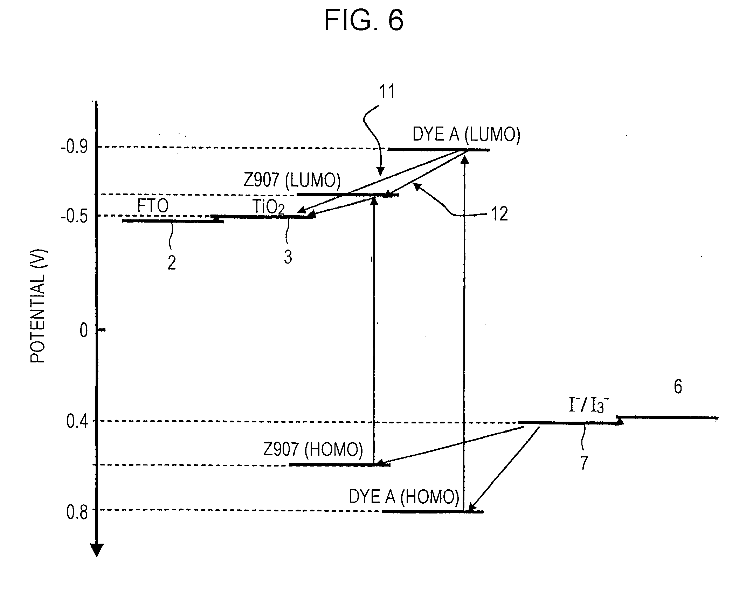

Fig. 6 is an energy diagram for explaining the operation principle of the dye-sensitized photoelectric conversion element. When light is incident, the dye-sensitized photoelectric conversion element operates as a cell including the counter electrode 6 serving as a positive electrode and the transparent electrode 2 serving as a negative electrode. The principle is as follows. In addition, although it is assumed herein that FTO is used as a material of the transparent electrode 2, TiO₂ is used as a material of the semiconductor layer 3, and I/I₃ oxidation/reduction species are used as a redox pair, the materials are not limited to these.

When the photosensitizing dyes bonded to the semiconductor layer 3, i.e., the Z907 and the dye A, absorb photons transmitted through the transparent substrate 1, the transparent electrode 2, and the semiconductor layer 3, electrons in the Z907 and the dye A are excited from a ground state (HOMO) to an excited state (LUMO). In this case, since the photosensitizing dyes include the Z907 and the dye A, light in a wider wavelength region can be absorbed at a high light absorptance as compared with a conventional dye-sensitized photoelectric conversion element including a single photosensitizing dye.

The electrons in the excited state are drawn to a conduction band of the semiconductor layer 3 through electric bonding between the photosensitizing dyes, i.e., the Z907 and the dye A, and the semiconductor layer 3, and reach the transparent electrode 2 through the semiconductor layer 3. In this case, the Z907 and the dye A have sufficiently different minimum excitation energies, in other words, HOMO - LUMO gaps, and are bonded in different configurations to the semiconductor layer 3, thereby causing little useless electron transfer between the Z907 and the dye A. Therefore, the Z907 and the dye A exhibit photoelectric conversion functions without decreasing the quantum yields of the Z907 and the dye A by each other, and the amount of current produced is greatly improved. In addition, in this system, there are two types of paths through which excited electrons of the dye A are drawn to the conduction band of the semiconductor layer 3. One of the paths is a direct path 11 through which the electrons in the excited state of the dye A are drawn directly to the conduction band of the semiconductor layer 3. The other one is an indirect path 12 through which the electrons in the excited state of the dye A are first drawn to an excited state of the Z907 at a lower energy level and then drawn from the excited state of the Z907 to the conduction band of the semiconductor layer 3. The contribution of the indirect path 12 improves the photoelectric conversion efficiency of the dye A in the system in which the dye A coexists with the Z907.

On the other hand, the Z907 and the dye A which lose electrons receive electrons from a reducing agent, for example, I⁻, in the electrolyte layer 7 according to the following reaction, thereby producing an oxidizing agent, for example, I₃⁻ (combination of I₂ and I⁻) in the electrolyte layer 7.

2I⁻ → I₂ + 2e⁻

I₂ + I⁻ → I₃⁻

The thus-produced oxidizing agent reaches the counter electrode 6 by diffusion and receives electrons from the counter electrode 6 through reverse reaction of the above reaction to be reduced to the initial reducing agent.

I₃⁻ → I₂ +I⁻

I₂ + 2e⁻ → 2I⁻

The electrons transferred to an external circuit from the transparent electrode 2 perform an electric work in the external circuit and then return to the counter electrode 6. In this way, light energy is converted to electric energy without leaving any change in the photosensitizing dyes, i.e., the Z907 and the dye A, and the electrolyte layer 7.

### (EXAMPLE 1)

The paste dispersion solution of TiO₂ used as a raw material for forming the semiconductor layer 3 was prepared with reference to "Latest Technology of Dye-Sensitized Solar Cell" (edited by Hironori ARAKAWA, 2001, CMC Co., Ltd.). That is, first, 125 ml of titanium isopropoxide was slowly added dropwise to 750 ml of a 0.1 M aqueous nitric acid solution under stirring at room temperature. After the addition, the resultant mixture was transferred to a constant-temperature bath of 80°C and continuously stirred for 8 hours to produce a cloudy semitransparent sol solution. The sol solution was allowed to cool to room temperature and filtered with a glass filter, and then a solvent was added up to a solution volume of 700 ml. The resultant sol solution was transferred to an autoclave, subjected to hydrothermal reaction at 220°C for 12 hours, and then subjected to dispersion treatment by ultrasonic treatment for 1 hour. Next, the solution was concentrated at 40°C using an evaporator and adjusted so that the content of TiO₂ was 20 wt%. Then, polyethylene glycol (molecular weight 500,000) equivalent to 20% of the mass of TiO₂ and anatase-type TiO₂ with a particle diameter of 200 nm equivalent to 30% of the mass of TiO₂ were added to the concentrated sol solution and uniformly mixed using a stirring deaerator to produce a TiO₂ paste dispersion solution with increased viscosity.

The TiO₂ paste dispersion solution was applied on a FTO layer serving as the transparent electrode 2 by the blade coating method to form a fine particle layer with a size of 5 mm x 5 mm and a thickness of 200 µm. Then, the TiO₂ fine particles were sintered on the FTO layer by maintaining at 500°C for 30 minutes. A 0.1 M aqueous titanium (IV) chloride TiCl₄ solution was added dropwise to the sintered TiO₂ film which was then maintained at room temperature for 15 hours, washed, and again fired at 500°C for 30 minutes. Then, the TiO₂ sintered body was irradiated with ultraviolet light for 30 minutes using an ultraviolet irradiation device so that impurities such as organic substances contained in the TiO₂ body were removed by oxidative decomposition through photocatalysis of TiO₂ and activity of the TiO₂ body was enhanced, thereby forming the semiconductor layer 3.

As the photosensitizing dyes, 23.8 mg of sufficiently purified Z907 and 2.5 mg of dye A were dissolved in 50 ml of a mixed solvent prepared by mixing acetonitrile and tert-butanol at a volume ratio of 1:1 (hereinafter, abbreviated as a "mixed solvent of acetonitrile and tert-butanol") to prepare a photosensitizing dye solution.

Next, the semiconductor layer 3 was immersed in the photosensitizing dye solution at room temperature for 24 hours to support the photosensitizing dyes on the surfaces of the TiO₂ fine particles. Next, the semiconductor layer 3 was washed using an acetonitrile solution of 4-tert-butylpyridine and acetonitrile in order, and then the solvent was evaporated in the dark, followed by drying.

The counter electrode 6 was formed by laminating, by the sputtering method, in order a chromium layer of 50 nm in thickness and a platinum layer of 100 nm in thickness on the FTO layer in which an injection hole with a diameter of 0.5 mm was previously formed, spray-coating an isopropyl alcohol (2-propanol) solution of chloroplatinic acid on the layers, and then heating at 385°C for 15 minutes.
Next, the transparent substrate 1 and the counter substrate 4 were disposed so that the semiconductor layer 3 and the counter electrode 6 faced each other, and the peripheries were sealed with an ionomer resin film of 30 µm in thickness and an acrylic ultraviolet curable resin.

On the other hand, 0.030 g of sodium iodide NaI, 1.0 g of 1-propyl-2,3-dimethylimidazolium iodide, 0.10 g of iodine I₂, and 0.054 g of 4-tert-butylpyridine (TBP) were dissolved in 2.0 g of 3-methoxypropionitrile (solvent) to prepare an electrolytic solution.

The electrolytic solution was injected into a previously prepared dye-sensitized photoelectric conversion element through an injection hole using a feed pump, and bubbles in the element were removed by pressure reduction. As a result, the electrolyte layer 7 was formed. Next, the injection hole was sealed with the ionomer resin film, the acrylic resin, and the glass substrates to complete the dye-sensitized photoelectric conversion element.

### (COMPARATIVE EXAMPLE 1)

An electrolytic solution was prepared using acetonitrile as a solvent in place of 3-methoxypropionitrile. With the exception of this, a dye-sensitized photoelectric conversion element was manufactured by the same method as in Example 1.

### (COMPARATIVE EXAMPLE 2)

Black dye (abbreviated as "BD") and dye A were used as photosensitizing dyes to be bonded to the semiconductor layer 3 in place of Z907 and dye A. With the exception of this, a dye-sensitized photoelectric conversion element was manufactured by the same method as in Example 1.

### (COMPARATIVE EXAMPLE 3)

Black dye (abbreviated as "BD") and dye A were used as photosensitizing dyes to be bonded to the semiconductor layer 3 in place of Z907 and dye A, and an electrolytic solution was prepared using acetonitrile as a solvent in place of 3-methoxypropionitrile. With the exception of this, a dye-sensitized photoelectric conversion element was manufactured by the same method as in Example 1.

### <Evaluation of performance of dye-sensitized photoelectric conversion element>

For the dye-sensitized photoelectric conversion element of Example 1 formed as described above, a photoelectric conversion efficiency was measured based on a current-voltage curve in irradiation with pseudo solar light (AM 1.5, 100 mw/cm²). As a result, the photoelectric conversion efficiency of the dye-sensitized photoelectric conversion element including the Z907 and the dye A bonded to the semiconductor layer 3 was 7.3%. This value of photoelectric conversion efficiency is higher than a photoelectric conversion efficiency of 4.3% when the dye A was singly bonded to the semiconductor layer 3 and a photoelectric conversion efficiency of 6.6% when the Z907 was singly bonded to the semiconductor layer 3.

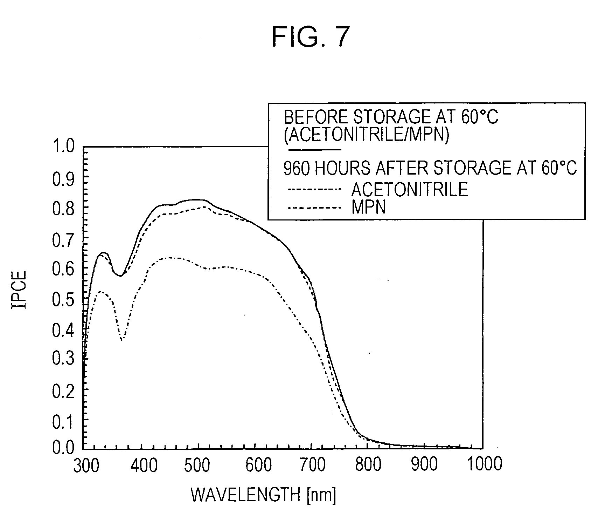

In order to confirm the long-term reliability of the dye-sensitized photoelectric conversion element within a short time, an accelerated deterioration test was performed by storing the dye-sensitized photoelectric conversion element in an environment of 60°C for a long time (960 hours). The results are shown in Fig. 7. Fig. 7 also shows the results of the accelerated deterioration test for the dye-sensitized photoelectric conversion elements of the comparative examples. As shown in Fig. 7, in the dye-sensitized photoelectric conversion elements of the comparative examples using acetonitrile as the solvent for the electrolyte layers 7, IPCE is greatly decreased after the accelerated deterioration test, and thus the photoelectric conversion performance is significantly decreased. In contrast, in the dye-sensitized photoelectric conversion element of the example using 3-methoxypropionitrile as the solvent for the electrolyte layer 7, IPCE is little decreased after the accelerated deterioration test, and the photoelectric conversion performance is little changed.

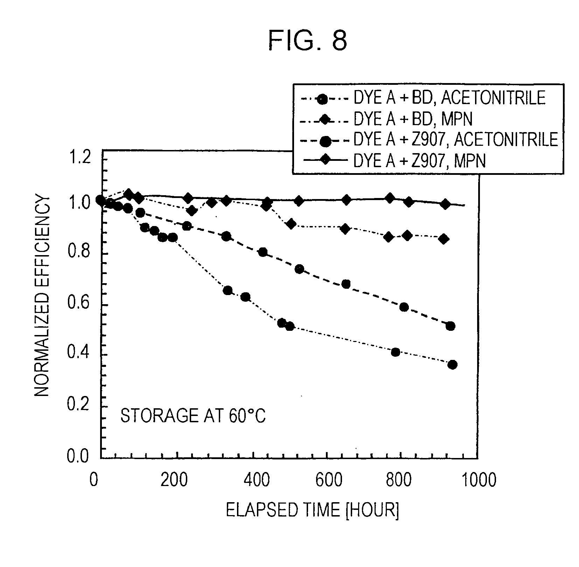

The dye-sensitized photoelectric conversion elements of Example 1 and Comparative Examples 1 to 3 were stored in an environment of 60°C to measure changes with time of photoelectric conversion efficiency. The results are shown in Fig. 8. In Fig. 8, normalized photoelectric conversion efficiencies (normalized efficiencies) determined by current-voltage measurement of the dye-sensitized photoelectric conversion elements are shown on the ordinate. As shown in Fig. 8, in the dye-sensitized photoelectric conversion elements of Comparative Examples 1 to 3, the photoelectric conversion efficiency is significantly decreased over time, while in the dye-sensitized photoelectric conversion element of Example 1, the photoelectric conversion efficiency is little decreased after the passage of 960 hours. This indicates that the dye-sensitized photoelectric conversion element of Example 1 has high durability and excellent long-term reliability.

As described above, according to the first embodiment, Z907 and dye A are used as photosensitizing dyes to be bonded to the semiconductor layer 3, and 3-methoxypropionitrile is used as a solvent for preparing the electrolyte layer 7. Therefore, a dye-sensitized photoelectric conversion element causing little decrease in photoelectric conversion efficiency over time and having high durability and excellent long-term reliability can be produced.

### (2. Second Embodiment)

### [Dye-sensitized photoelectric conversion element]

In a dye-sensitized photoelectric conversion element according to a second embodiment, a nanocomposite gel composed of an electrolytic solution using 3-methoxypropionitrile as a solvent and nanoparticles of TiO₂ or SiO₂ is used as an electrolyte layer 7. The other configuration of the dye-sensitized photoelectric conversion element is the same as the dye-sensitized photoelectric conversion element according to the first embodiment.

### [Method for manufacturing dye-sensitized photoelectric conversion element]

The method for manufacturing the dye-sensitized photoelectric conversion element is the same as the dye-sensitized photoelectric conversion element according to the first embodiment except that the electrolyte layer 7 is formed using a nanocomposite gel composed of an electrolytic solution using 3-methoxypropionitrile as a solvent and nanoparticles of TiO₂ or SiO₂.

### (EXAMPLE 2)

About 10% of nanoparticles composed of SiO₂ were added and mixed with an electrolytic solution prepared by adding the same electrolyte as in Example 1 to 3-methoxypropionitrile used as a solvent, preparing a gel as a nanocomposite gel which was used for the electrolyte layer 7. With the exception of this, a dye-sensitized photoelectric conversion element was manufactured by the same method as in Example 1.

### (Evaluation of performance of dye-sensitized photoelectric conversion element)

For the dye-sensitized photoelectric conversion element of Example 2 formed as described above, a photoelectric conversion efficiency was measured based on a current-voltage curve in irradiation with pseudo solar light (AM 1.5, 100 mw/cm²) was measured. As a result, the photoelectric conversion efficiency of the dye-sensitized photoelectric conversion element including the Z907 and the dye A bonded to the semiconductor layer 3 was 8.5%. This value of photoelectric conversion efficiency is higher than a photoelectric conversion efficiency of 5.1% when the dye A was singly bonded to the semiconductor layer 3 and a photoelectric conversion efficiency of 7.5% when the Z907 was singly bonded to the semiconductor layer 3.
According to the second embodiment, the same advantages as in the first embodiment can be obtained.

Although the embodiments and the examples of the present invention are described in detail above, the present invention is not limited to the above-described embodiments and the examples, and various modifications based on the technical idea of the present invention can be made.
For example, the numerical values, structures, configurations, shapes, material, etc. described in the embodiments and the examples are just only examples, and numerical values, structures, configurations, shapes, material, etc. different from these may be used according to demand.

### Reference Signs List

1 ... transparent substrate, 2 ... transparent electrode, 3 ... semiconductor layer, 4 ... counter substrate, 5 ... transparent conductive layer, 6 ... counter electrode, 7 ... electrolyte layer

## Claims

1. A dye-sensitized photoelectric conversion element comprising:
a structure in which an electrolyte layer is filled between a semiconductor layer and a counter electrode,
wherein Z907 and dye A are bonded as photosensitizing dyes to the semiconductor layer; and
the electrolyte layer contains 3-methoxypropionitrile as a solvent.

2. The dye-sensitized photoelectric conversion element according to Claim 1, wherein the Z907 and the dye A are bonded in different configurations to the semiconductor layer.

3. The dye-sensitized photoelectric conversion element according to Claim 2, wherein the Z907 has a carboxyl group as a functional group to be bonded to the semiconductor layer.

4. The dye-sensitized photoelectric conversion element according to Claim 3, wherein the dye A has a carboxyl group and a cyano group as functional groups to be bonded to the semiconductor layer, both groups being bonded to the same carbon.

5. The dye-sensitized photoelectric conversion element according to Claim 1, wherein the semiconductor layer contains TiO₂.

6. The dye-sensitized photoelectric conversion element according to Claim 5, wherein the TiO₂ is an anatase type.

7. The dye-sensitized photoelectric conversion element according to Claim 1, wherein the electrolyte layer is composed of an electrolytic solution or a gel or solid electrolyte.

8. The dye-sensitized photoelectric conversion element according to Claim 1, wherein the electrolyte layer is composed of a nanocomposite gel including an electrolytic solution and nanoparticles.

9. The dye-sensitized photoelectric conversion element according to Claim 8, wherein the nanoparticles are composed of TiO₂ or SiO₂.

10. A method for manufacturing a dye-sensitized photoelectric conversion element comprising:
a step of bonding Z907 and dye A as photosensitizing dyes to a semiconductor layer; and
a step of forming a structure in which an electrolyte layer is filled between the semiconductor layer and a counter electrode, the electrolyte layer containing 3-methoxypropionitrile as a solvent in this step.

11. The method for manufacturing a dye-sensitized photoelectric conversion element according to Claim 10, wherein the Z907 has a carboxyl group as a functional group to be bonded to the semiconductor layer.

12. The method for manufacturing a dye-sensitized photoelectric conversion element according to Claim 11, wherein the dye A has a carboxyl group and a cyano group as functional groups to be bonded to the semiconductor layer, both groups being bonded to the same carbon.

13. The method for manufacturing a dye-sensitized photoelectric conversion element according to Claim 10, wherein the semiconductor layer contains TiO₂.

14. An electronic apparatus comprising:
at least one dye-sensitized photoelectric conversion element,
wherein the dye-sensitized photoelectric conversion element is a dye-sensitized photoelectric conversion element having a structure in which an electrolyte layer is filled between a semiconductor layer and a counter electrode;
Z907 and dye A are bonded as photosensitizing dyes to the semiconductor layer; and
the electrolyte layer contains 3-methoxypropionitrile as a solvent.
